# EUROPEAN PATENT APPLICATION

(11) **EP 4 614 099 A1**
(43) Date of publication of application: **10.09.2025**
(21) Application number: 25161123.2
(22) Date of filing: 28.02.2025
(51) Int. Cl.: F28D 15/02, F28F 3/04

(54) **HEAT SINK AND DISPLAY DEVICE INCLUDING THE SAME**

(30) Priority: 05.03.2024 KR 20240031516
(71) Applicant: Samsung Display Co., Ltd., Yongin-si, Gyeonggi-do 17113 (KR)
(72) Inventor: SON, Jun Hee, 17113 Yongin-si (KR); KIM, Sung Hoon, 17113 Yongin-si (KR); PARK, Haeng Won, 17113 Yongin-si (KR); BAE, Hyun Chul, 17113 Yongin-si (KR); HWANG, Sang Ho, 17113 Yongin-si (KR)
(74) Representative: Taor, Simon Edward William

(57) **Abstract**

A display device includes: a display panel; and a heat sink under the display panel, wherein the heat sink includes: a main body including a base and fins that protrude downward from the base and are spaced apart from each other; and a heat pipe formed inside the main body and having a path passing through the base and the fins.

## Description

### CROSS-REFERENCE TO RELATED APPLICATION

The present application claims priority to and the benefit of Korean Patent Application No. 10-2024-0031516 filed in the Korean Intellectual Property Office on March 5, 2024.

### BACKGROUND

### 1. Field

Aspects of some embodiments of the present disclosure relate to a heat sink and a display device including the same.

### 2. Description of the Related Art

High power may be used to increase the luminance of a display panel, but this results in a temperature increase. For example, a display panel applied to a head mounted display (HMD) may desirably have high heat dissipation performance as well as high resolution and high luminance. This is because the head mounted display device may be positioned close to the user's eyes, heat generation from the display panel may be fatal to the user. Heat plates, heat sinks, and the like may be used as heat dissipation components for lowering the temperature of the display panel.

The above information disclosed in this Background section is only for enhancement of understanding of the background and therefore the information discussed in this Background section does not necessarily constitute prior art.

### SUMMARY

Aspects of some embodiments of the present disclosure include a heat sink having relatively high heat dissipation performance and a display device including the same.

Characteristics of embodiments according to the present disclosure are not limited to the characteristics mentioned above, and other characteristics that are not mentioned may be more clearly understood to a person of an ordinary skill in the art using the following description.

Aspects of some embodiments of the present disclosure include a display device including: a display panel; and a heat sink under the display panel. According to some embodiments, the heat pipe includes a main body including a base and fins that protrude downward from the base and are spaced apart from each other; and a heat pipe formed inside the main body and having a path passing through the base and the fins.

According to some embodiments, the heat pipe may be a pulsating heat pipe.

According to some embodiments, the heat pipe may not be connected to an external device or a power source.

According to some embodiments, the fins may be arranged along a first direction, the heat pipe may extend inside each of the fins along a first rotation direction perpendicular (or substantially perpendicular) to the first direction, and the heat pipe may have a spiral structure extending along the first direction; and

According to some embodiments, each of the fins may be a plate fin, and the heat pipe may extend along an edge of each of the fins.

According to some embodiments, the heat pipe may have an open loop structure, and one end portion of the heat pipe may be connected to the other end portion of the heat pipe only through a single path.

According to some embodiments, the heat pipe may have a single closed loop structure.

According to some embodiments, the heat pipe may have a double spiral structure extending along the first direction.

According to some embodiments, the heat pipe may include a first spiral structure passing through odd-numbered fins among the fins, and a second spiral structure passing through even-numbered fins among the fins, and the first spiral structure and the second spiral structure may be connected to each other at both end portions of the base in the first direction to form the closed loop structure.

According to some embodiments, the heat pipe may pass through only some of the fins.

According to some embodiments, in a cross-sectional view, the heat pipe may be on at least two layers that are separated from each other along a third direction in which the fins protrude from the base.

According to some embodiments, in a cross-sectional view, the heat pipe may be on three layers.

According to some embodiments, the fins may be sequentially arranged along a first direction, and the heat pipe may include closed loops respectively corresponding to the fins; and a first bridge extending in the first direction inside the base and connected to the closed loops, and the closed loops and the first bridge may be integrally formed.

According to some embodiments, the first bridge may be closer to an edge of the base than a center of an area of the base.

According to some embodiments, the first bridge may be closer to a center of an area of the base than an edge of the base.

According to some embodiments, the heat pipe may further include a second bridge connecting the closed loops at end portions of the fins.

According to some embodiments, the heat sink may be coupled to a lower surface of the display panel by a heat dissipation adhesive or a single heat dissipation adhesive layer.

According to some embodiments, a filling rate of a working fluid in the heat pipe may be 40% to 70% (or about 40% to about 70%).

Aspects of some embodiments of the present disclosure include a heat pipe including: a main body including a base and fins that protrude downward from the base and are spaced apart from each other; and a heat pipe formed inside the main body and having a path passing through the base and the fins.

According to some embodiments, the fins may be sequentially arranged along a first direction; the heat pipe may extend inside each of the fins along a first rotation direction perpendicular (or substantially perpendicular) to the first direction, and the heat pipe may have a spiral structure extending along the first direction; and the heat pipe may have an open loop structure.

Characteristics of other embodiments are included in the detailed description and drawings.

The heat sink and display device according to some embodiments of the present disclosure includes a heat pipe located on a base and fins (or two layers) and having a structure (for example, a spiral structure) that passes entirely through the heat sink, and may more quickly diffuse heat from the display panel throughout the fins through the heat pipes, and may more quickly release heat to the outside using all the fins.

According to an aspect, there is a heat sink as set out in claim 1. Additional features are set out in claims 2 to 13. According to an aspect, there is a display device as set out in claim 14. Additional features are set out in claim 15.

Characteristics of embodiments of the present disclosure are not limited by what is illustrated in the above, and more various effects are included in the present specification.

### BRIEF DESCRIPTION OF THE DRAWINGS

FIG. 1 illustrates a perspective view of a display device according to some embodiments.
FIG. 2 illustrates the display device of FIG. 1 worn by a user.
FIG. 3 illustrates a cross-sectional view according to some embodiments of the display device of FIG. 1.
FIG. 4 illustrates a cross-sectional view according to some embodiments of a heat sink included in the display device of FIG. 3.
FIG. 5 illustrates a perspective view according to some embodiments of the heat sink of FIG. 4.
FIG. 6 illustrates aspects of the heat sink of FIG. 4 taken along the line A-A' of FIG. 5.
FIG. 7 illustrates an operation of a heat pipe included in the heat sink of FIG. 4.
FIG. 8 illustrates a cross-sectional view of a comparative example of a display device.
FIG. 9 illustrates a perspective view of a comparative example of a heat sink.
FIG. 10 illustrates a perspective view of the heat sink of FIG. 4 according to some embodiments.
FIG. 11 and FIG. 12 illustrate cross-sectional views of a heat sink included in the display device of FIG. 3 according to some embodiments.
FIG. 13 and FIG. 14 illustrate perspective views of the heat sink of FIG. 4 according to some embodiments.
FIG. 15 illustrates a perspective view of the heat sink of FIG. 4 according to some embodiments.

### DETAILED DESCRIPTION

Hereinafter, aspects of some embodiments of the present disclosure will be described in more detail with reference to the accompanying drawings. The following description is intended to provide only a sufficient disclosure to enable the understanding of the operation of the invention, and any other disclosure is omitted to avoid obscuring the scope of the invention. In addition, the inventive concept may be embodied in different forms and is not limited to the embodiments set forth herein. The embodiments described herein are provided for the purpose of describing the technical concept of the invention in sufficient detail for those skilled in the art to easily practice it.

Throughout the specification, when it is described that an element is "connected" to another element, this includes not only being "directly connected", but also being "indirectly connected" with another device in between. The terms used herein are for the purpose of describing specific embodiments and are not intended to limit the scope of the invention. Throughout the specification, unless explicitly described to the contrary, the word "comprise" and variations such as "comprises" or "comprising" will be understood to imply the inclusion of stated elements but not the exclusion of any other elements. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms first, second, etc. may be used herein to describe various constituent elements, these constituent elements should not be limited by these terms. These terms are used to distinguish one constituent element from another. Thus, a first constituent element discussed below could be termed a second constituent element without departing from the teachings of the present disclosure.

Spatially relative terms, such as "beneath," "below," "lower," "above," "upper," and the like, may be used herein for descriptive purposes, and, thereby, to describe one element or feature's relationship to another element(s) or feature(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (for example, rotated 90 degrees or at other orientations), and, as such, the spatially relative descriptors used herein interpreted accordingly.

Hereinafter, a display device according to some embodiments of the present disclosure will be described in more detail with reference to drawings related to the disclosed embodiments of the present disclosure.

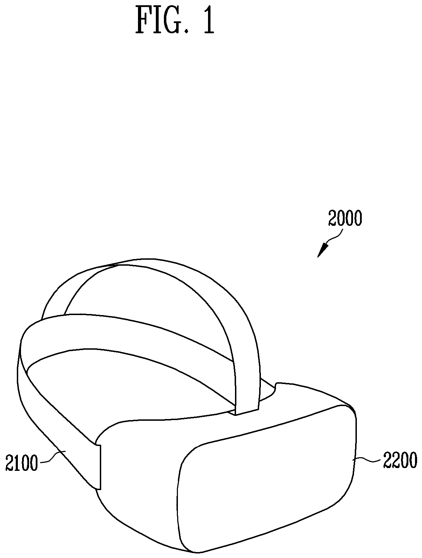

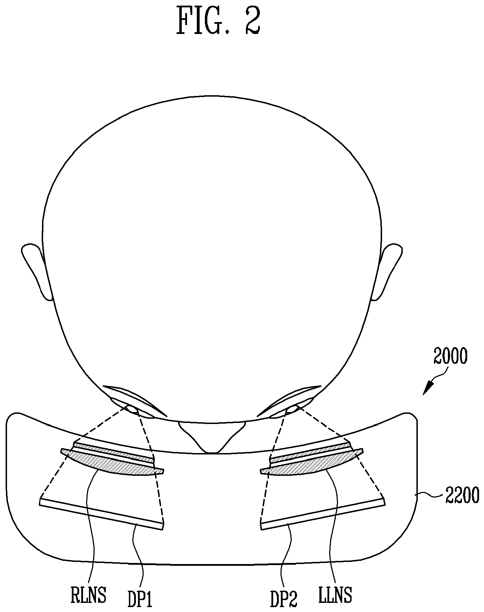

FIG. 1 illustrates a perspective view of a display device according to embodiments. FIG. 1 illustrates a display device applied to a head mounted display device 2000 (or a virtual reality (VR) device, a mixed reality (MR) device, or an augmented reality (AR) device). The head mounted display device 2000 may be a wearable electronic device that may be worn on the user's head. FIG. 2 illustrates the display device of FIG. 1 worn by a user.

Referring to FIG. 1 and FIG. 2, the head mounted display device 2000 may include a head mounted band 2100 and a display device accommodation case 2200. The head mounted band 2100 may be connected to the display device accommodation case 2200. The head mounted band 2100 may include a horizontal band and/or a vertical band for fixing the head mounted display device 2000 to the user's head. The horizontal band may be configured to surround the side portion of the user's head, and the vertical band may be configured to surround the upper portion of the user's head. However, embodiments according to the present disclosure are not limited thereto. For example, the head mounted band 2100 may be implemented in the form of a spectacle frame, a helmet, or the like.

The display device accommodation case 2200 may accommodate at least one display panel DP1 or DP2 and at least one lens LLNS or RLNS. At least one display panel DP1 or DP2 emits light. At least one lens LLNS or RLNS is located on at least one display panel DP1 or DP2 (or on an emission path of light).

In the display device accommodation case 2200, the right eye lens RLNS may be located between the first display panel DP1 and the right eye of the user. In the display device accommodation case 2200, the left eye lens LLNS may be located between the second display panel DP2 and the left eye of the user.

An image outputted from the first display panel DP1 may be shown to the right eye of the user through the right eye lens RLNS. The right eye lens RLNS may refract light from the first display panel DP1 to be directed to the right eye of the user. The right eye lens RLNS may perform an optical function to adjust the viewing distance between the first display panel DP1 and the right eye of the user.

An image outputted from the second display panel DP2 may be shown to the left of the user through the left eye lens LLNS. The left eye lens LLNS may refract light from the second display panel DP2 to be directed to the left eye of the user. The left eye lens LLNS may perform an optical function to adjust the viewing distance between the second display panel DP2 and the left eye of the user.

Meanwhile, in FIG. 1 and FIG. 2, an example in which the display device is applied to the head mounted display device 2000 requiring high heat dissipation performance has been described, but embodiments are not limited thereto. For example, the display device may be applied to a computing system providing image display functions such as a portable computer, a mobile phone, a smart phone, a tablet personal computer (PC), a smart watch, a watch phone, a portable multimedia player (PMP), a navigation system, and a ultra mobile personal computer (UMPC).

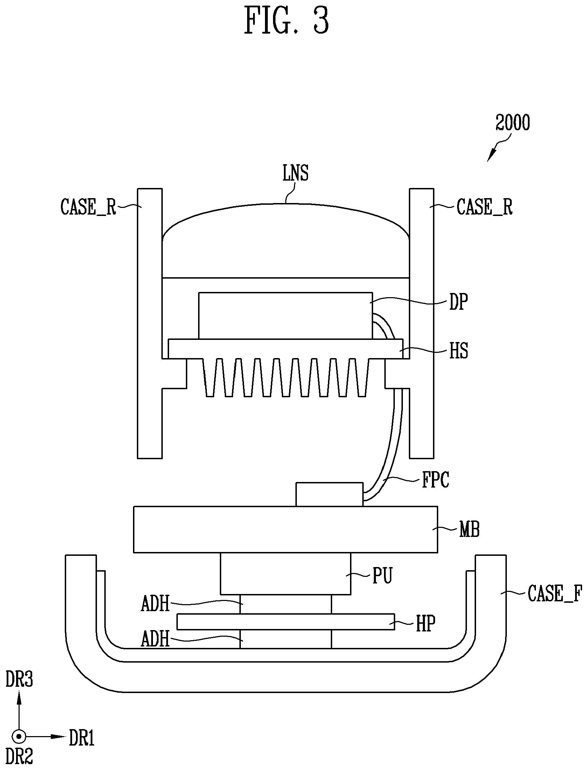

FIG. 3 illustrates a cross-sectional view of a display device of FIG. 1 according to some embodiments.

Referring to FIG. 3, the head mounted display device 2000 (or wearable electronic device or display device) may include a front case CASE_F, a rear case CASE_R, a display panel DP, a lens LNS, a processor PU, and a heat sink HS.

The front case CASE_F and the rear case CASE_R may configure the display device accommodation case 2200 of FIG. 1. The processor PU may be installed or fixed in the front case CASE_F, and the display panel DP, the lens LNS, and the heat sink HS may be installed or fixed in the rear case CASE_R. However, this is only an example, and embodiments according to the present disclosure are not limited thereto. For example, the processor PU may be installed in the rear case CASE_R.

The display panel DP displays an image. For example, the display panel DP may display an image in the third direction DR3. The display panel DP may be implemented as a self-luminous display panel, such as an organic light emitting display panel. In this case, the display panel DP may include an organic light emitting diode, an inorganic light emitting diode, and a quantum dot/well light emitting diode. However, the display panel DP of embodiments is not limited thereto. For example, the display panel DP may be implemented as a non-light emitting type of display panel such as a liquid crystal display panel.

The lens LNS may be located on the display panel DP. For example, the lens LNS may include an optical lens having a pancake-shaped cross section. In embodiments, the lens LNS may include a multi-channel lens including sub-areas having different optical properties. In this case, each display panel DP outputs images corresponding to the sub-areas of the multi-channel lens, and the output images may pass through the sub-areas and be viewed by the user.

The processor PU may perform various tasks and calculations. In embodiments, the processor PU may include an application processor, a graphics processor, a microprocessor, a central processing unit (CPU), and the like. For example, the processor PU is mounted on the main board MB, and the main board MB may be electrically connected to the display panel DP through the flexible circuit board FPC. A driving circuit for driving the display panel DP may be mounted on the main board MB and/or the flexible circuit board FPC. For example, the driving circuit includes a timing controller, data driver, and the like, and may be implemented as an integrated circuit (IC).

A heat plate HP may be located between the processor PU and the front case CASE_F. The heat plate HP may disperse heat generated from the processor PU, and the dispersed heat may be discharged to the outside through the front case CASE_F or through convection or radiation. The heat plate HP may be attached to the processor PU using an adhesive ADH (or an adhesive layer), and may also be attached to the front case CASE_F using the adhesive ADH. The adhesive ADH may include a thermal interface material (TIM).

The heat sink HS is located under the display panel DP. The heat sink HS may be fixed to the rear case CASE_R. The heat sink HS may be in direct or indirect thermal contact with the display panel DP, and may absorb heat from the display panel DP to emit it. The heat sink HS may include aluminum, copper, or the like having high thermal conductivity.

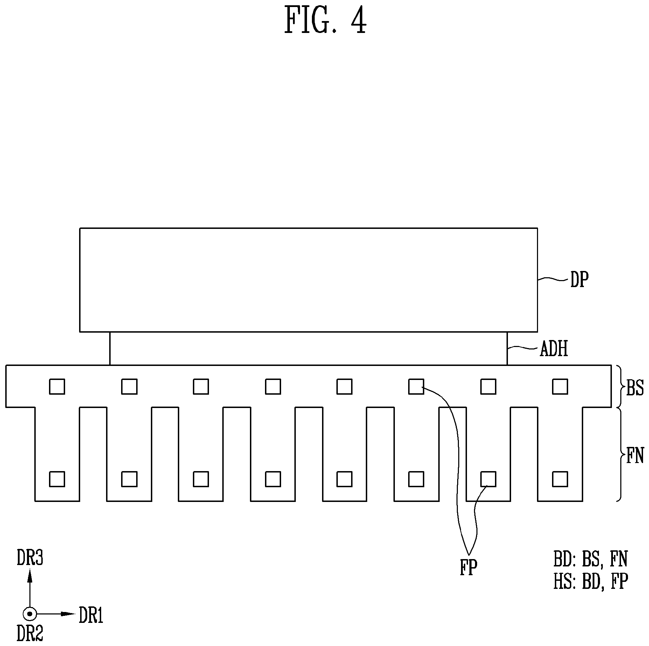

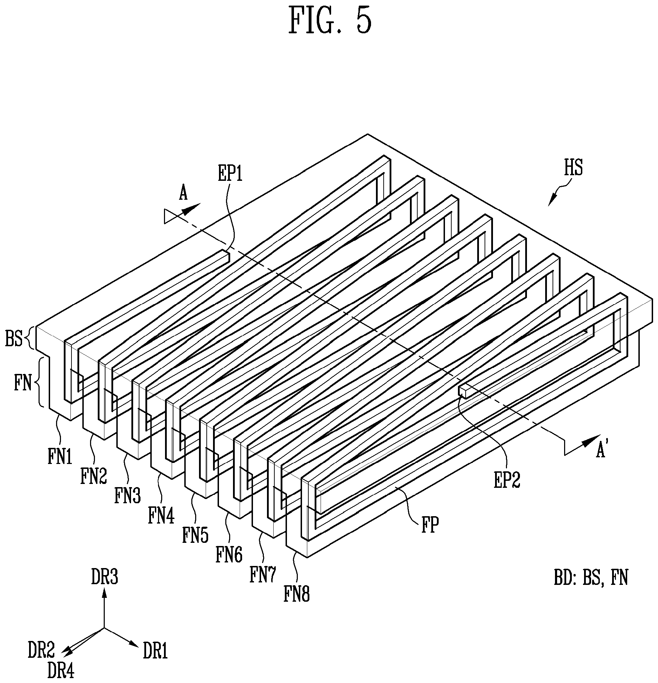

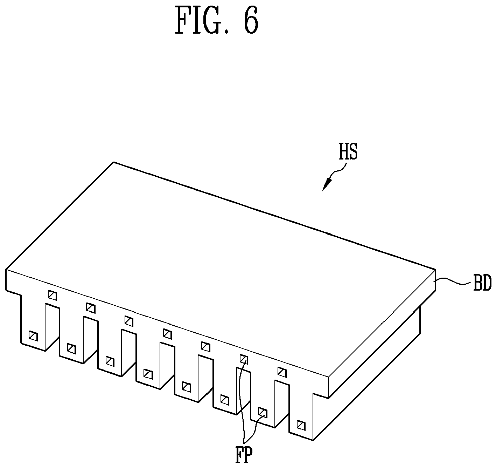

FIG. 4 illustrates a cross-sectional view of a heat sink included in the display device of FIG. 3 according to some embodiments. For better understanding and ease of description, the display panel DP is further illustrated in FIG. 4. FIG. 5 illustrates a perspective view of the heat sink of FIG. 4 according to some embodiments. FIG. 6 illustrates aspects of the heat sink of FIG. 4 taken along the line A-A' of FIG. 5.

Referring to FIG. 4 to FIG. 6, the heat sink HS may be coupled to the lower surface of the display panel DP by the adhesive ADH. The adhesive ADH may be a heat dissipation adhesive or a single heat dissipation adhesive layer. For example, the adhesive ADH may include a thermal interface material (TIM). The thermal interface material is a filling material that fills the fine gap between the heat source and the radiator for effectively thermal interfacing from the heat source to the radiator. The adhesive ADH including the thermal interface material fills the fine gap between the display panel DP and the heat sink HS, and at least a portion of the heat sink HS may directly contact the display panel DP.

The heat sink HS may include a heat pipe FP (or flow path). That is, the heat pipe FP may be embedded in the heat sink HS.

A main body BD may include a base BS and fins FN.

The base BS has a plate shape having a surface corresponding to one surface of the display panel DP.

The fins FN protrude downward from the base BS (or in a direction opposite to the third direction DR3). The fins FN have a plate shape extending in the second direction DR2, and may be arranged to be spaced apart from each other along the first direction DR1. For example, each of the fins FN may be a plate fin. The fins FN may be integrally formed with the base BS. Eight fins FN1 to FN8 are illustrated in FIG. 5, but this is only an example, and the number of fins FN is not particularly limited.

The heat pipe FP may be formed inside the main body BD. For example, a tube-shaped cavity may be formed inside the body BD, and the cavity may be filled with a working fluid to form the heat pipe FP. The cross-sectional shape of the heat pipe FP (or tube) may be quadrangular, but embodiments according to the present disclosure are not limited thereto. For example, the cross-sectional shape of the heat pipe FP (or tube) may be circular.

The heat pipe FP has a path passing through the base BS and the fins FN.

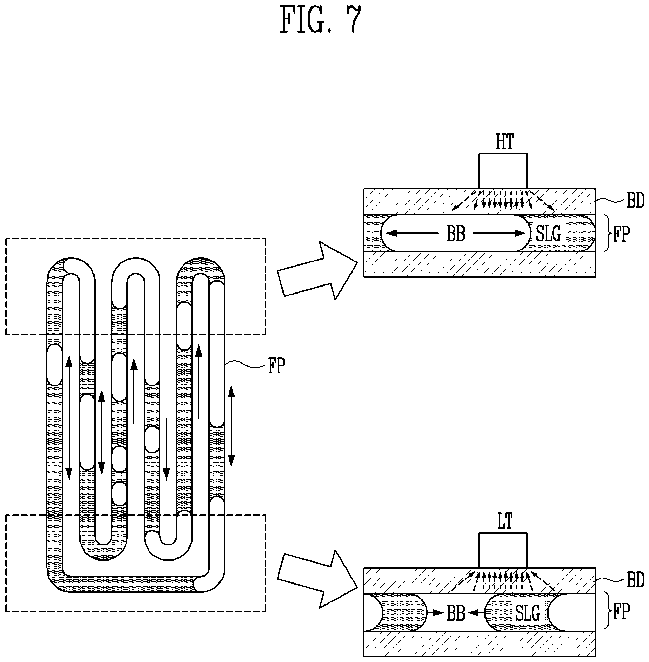

According to some embodiments, the heat pipe FP may be a pulsating heat pipe (PHP). An operation of the heat pipe FP will be described in more detail later with reference to FIG. 7. The heat pipe FP is a passive element and is not connected to an external device or a power source.

According to some embodiments, in a cross-sectional view, the heat pipe FP may be located on at least two layers separated from each other along the third direction DR3. For example, as shown in FIG. 4, the heat pipe FP may be located on the first layer corresponding to the base BS and the second layer corresponding to the fins FN.

According to some embodiments, the heat pipe FP may extend along a first rotation direction perpendicular to the first direction DR1 inside each of the fins FN, and the heat pipe FP may have a spiral structure entirely extending in the first direction DR1.

For example, the heat pipe FP may have a spiral structure extending from the first end portion EP1 toward the second end portion EP2. The heat pipe FP may sequentially extend in the direction opposite to the third direction DR3, the direction opposite to the second direction DR2, and the third direction DR3 inside the first fin FN1, except for the base BS. Thereafter, the heat pipe FP may extend in the fourth direction DR4 from one side of the first fin FN1 toward the other side of the second fin FN2 within the base BS. In this way, the heat pipe FP may sequentially pass through the second fin FN2, the third fin FN3, the fourth fin FN4, the fifth fin FN5, the sixth fin FN6, the seventh fin FN7, and the eighth fin FN8. The heat pipe FP may extend along an edge of each of the fins FN, but embodiments according to the present disclosure are not limited thereto.

Because the heat pipe FP has a spiral structure, heat transmitted from the display panel DP to the heat sink HS (or base BS) may diffuse throughout the fins FN, and heat may be dissipated through all of the fins FN. For example, when heat is concentrated and transmitted from the display panel DP to the central portion of the heat sink HS (or base BS), heat may diffuse in the fourth direction DR4 (or in the second direction DR2 and/or the direction opposite the second direction DR2) through the heat pipe FP extending in the fourth direction DR4 from the base BS, and heat may diffuse in the first direction DR1 (and/or the direction opposite to the first direction DR1) through the spiral heat pipe FP. That is, the heat transmitted to at least a portion of the heat sink HS is quickly spread throughout the heat sink HS through the heat pipe FP, and the heat may be rapidly dissipated using all of the fins FN of the heat sink HS.

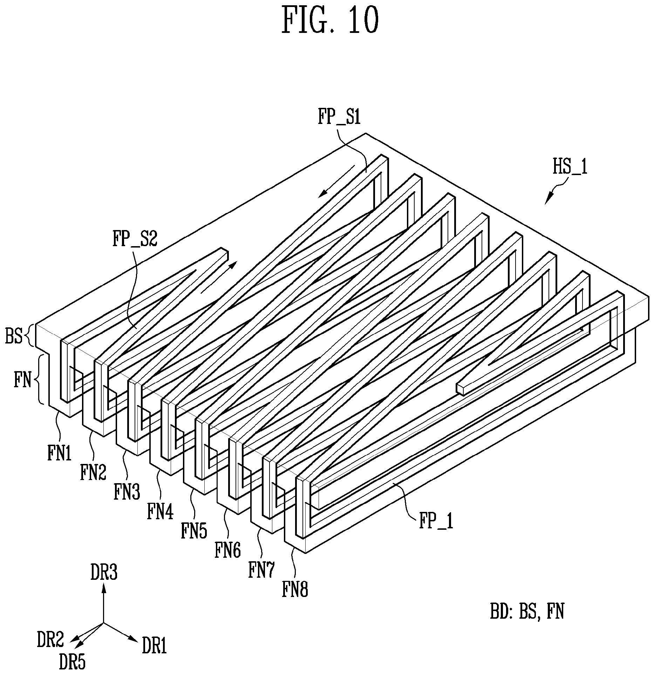

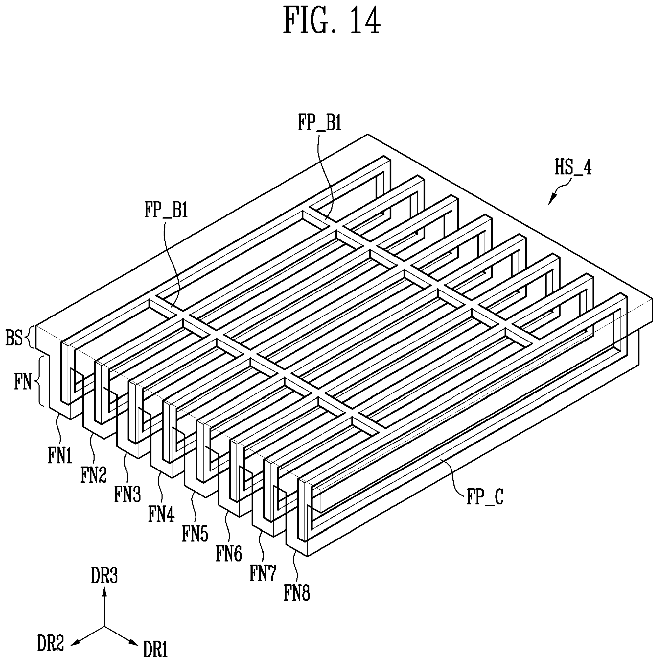

According to some embodiments, the heat pipe FP may have an open loop structure. In this case, the first end portion EP1 and the second end portion EP2 of the heat pipe FP may be connected only through a single path. However, the heat pipe FP of embodiments is not limited thereto. For example, the heat pipe FP may have a closed loop structure (see FIG. 10). As another example, the first end portion EP1 and the second end portion EP2 of the heat pipe FP may be connected through a bridge (see FP_B1 of FIG. 14).

As described above, the heat sink HS includes the heat pipe FP located on the base BS and the fins FN (or two layers) and having a structure (for example, spiral structure) that entirely passes through the heat sink HS, and the heat sink HS may diffuse the heat of the display panel DP more quickly throughout the fins FN through the heat pipe FP, and may dissipate the heat to the outside more quickly by using all of the fins FN.

FIG. 7 illustrates an operation of a heat pipe included in the heat sink of FIG. 4.

Referring to FIG. 4 to FIG. 7, a working fluid SLG (or liquid plug) is filled in a small diameter pipe of the heat pipe FP, and the working fluid SLG and a bubble BB (or vapor bubble or vapor plug) are repeatedly formed by capillary force.

The working fluid SLG pulsates due to pressure changes in the bubble BB caused by the heat source HT (for example, the display panel DP), and the working fluid SLG pulsates and/or circulates depending on the amount of heat. Heat is transmitted from the heat source HT to the heat pipe FP (and through the main body BD to the low temperature portion LT (for example, outside the fins FN). That is, the heat pipe FP (or pulsating heat pipe) is a two-phase heat transmission device that transmits heat through pulsation/circulation movement of the working fluid SLG in microtubules.

Water, freon, methanol, ethanol, and the like are used as the working fluid SLG, and the filling rate of the working fluid SLG may be 50% (or about 50 %). For example, to facilitate the pulsation/circulation movement of the working fluid SLG, the heat pipe FP (or microtube) may be filled with 40% to 70% (or about 40 % to about 70 %) of the working fluid SLG.

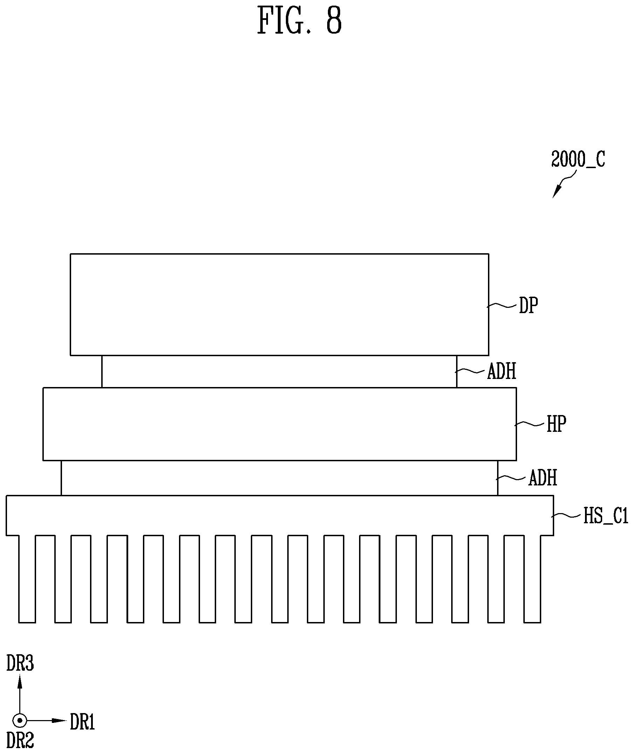

FIG. 8 illustrates a cross-sectional view of a comparative example of a display device. FIG. 8 illustrates a comparative example of a display device applied to a head mounted display device 2000_C.

Referring to FIG. 8, the head mounted display device 2000_C according to the comparative example includes a display panel DP, a heat plate HP, and a heat sink HS_C1.

The heat sink HS_C1 according to the comparative example does not include a heat pipe, and accordingly, the heat plate HP is located between the display panel DP and the heat sink HS_C1.

The heat plate HP is attached to the lower portion of the display panel DP using an adhesive ADH, and may disperse heat generated from the display panel DP.

The heat sink HS_C1 according to the comparative example is attached to the lower portion of the heat plate HP by using an adhesive ADH, and may absorb heat dispersed by the heat plate HP to discharge the heat to the outside.

Although the heat plate HP is used to disperse heat, the thermal conductivity of the heat plate HP of a single material is at the level of hundreds of W/m·K, and there is a limit to dispersing (and discharging) heat only with the heat plate HP of the single material. For example, the thermal conductivity of aluminum is 234 W/m·K (or about 234 W/m·K), and that of copper is 386 W/m·K (or about 386 W/m·K). Particularly, because the display panel DP applied to the head mounted display device 2000_C has high resolution and high luminance and generates a lot of heat in a small area, it is difficult to lower the temperature of the display panel DP (and the head mounted display device 2000_C) only with the stacked structure of the heat plate HP and the heat sink HS_C1.

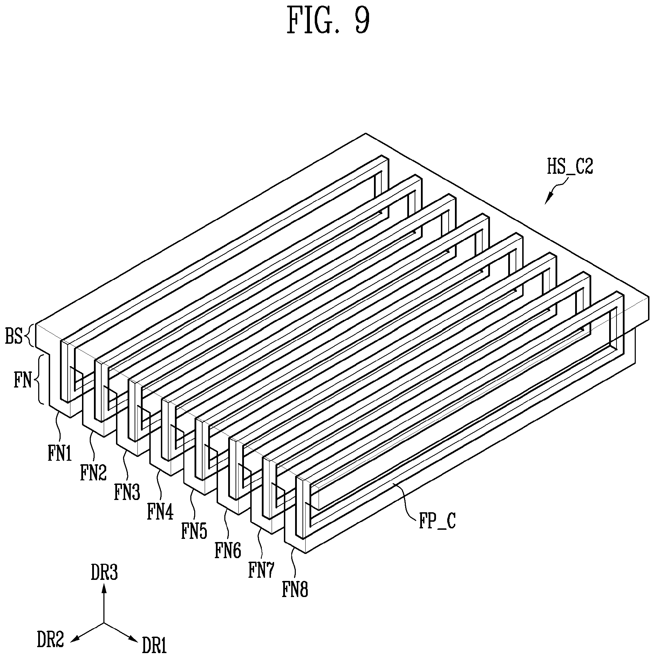

FIG. 9 illustrates a perspective view of a comparative example of a heat sink.

Referring to FIG. 4 and FIG. 9, a heat sink HS_C2 according to a comparative example may include a heat pipe FP_C.

Each heat pipe FP_C is located inside each of the fins FN, and may have a closed loop structure inside each of the fins FN. Each heat pipe FP_C is independent, and may be physically separated from the heat pipe FP_C formed in an adjacent fin. For example, the heat pipe FP_C formed in the first fin FN1 is not connected to the heat pipe FP_C formed in the second fin FN2.

For example, when heat is concentrated and transmitted from the display panel DP to the central portion of the heat sink HS_C2, heat is diffused through the heat pipe FP_C inside the third to sixth fins FN3 to FN6, and the heat pipe FP_C inside at least the first and eighth fins FN1 and FN8 may not be directly involved in heat transmission. That is, compared with the heat sink HS of FIG. 5, heat may slowly diffuse throughout the heat sink HS_C2 of FIG. 9.

**(Table 1)**

| Category (°C) | 3 W | 10 W | 15 W |
|---|---|---|---|
| CASE1 | 31.6 °C | 56.5 °C | 73.5 °C |
| CASE2 (HS_C1) | 27.1 °C | 41.9 °C | 52.1 °C |
| CASE3 (HS_C2) | 24.5 °C | 32.7 °C | 38.0 °C |
| CASE4 (HS) | 23.5 °C | 29.8 °C | 33.8 °C |

Table 1 shows the temperature in the display device (for example, on the surface of the display panel DP (see FIG. 4)) by power consumption. The first case CASE1 is a display device to which a heat sink is not applied, the second case CASE2 is a display device to which the heat sink HS_C1 (and the heat plate HP) according to the comparative example of FIG. 8 is applied, the third case CASE3 is a display device to which the heat sink HS_C2 according to the comparative example of FIG. 9 is applied, and the fourth case CASE4 is a display device to which the heat sink HS of FIG. 4 and FIG. 5 is applied. In the second to fourth cases CASE2 to CASE4, the display panel DP is located in the central portion of the heat sink HS_C1, HS_C2, or HS.

As shown in Table 1, based on the same power consumption (for example, power consumption of 3 W, 10 W, and 15 W, respectively), the temperature is low in the order of the first case CASE1, the second case CASE2, the third case CASE3, and in the fourth case (CASE4).

For example, when the power consumption is 3 W, the temperature according to the fourth case CASE4 is lower by 1.0 °C to 7.1 °C (or about 1.0 °C to about 7.1 °C) compared to other cases CASE1 to CASE3. When the power consumption is 10 W, the temperature according to the fourth case CASE4 is lower by 2.9 °C to 26.7 °C (or about 2.9 °C to about 26.7 °C) compared to other cases CASE1 to CASE3. When the power consumption is 15 W, the temperature according to the fourth case CASE4 is lower by 4.2 °C to 39.7 °C (or about 4.2 °C to about 39.7 °C) compared to other cases CASE1 to CASE3.

As power consumption increases, the temperature of the fourth case CASE4 may be lowered more compared to the other cases CASE1 to CASE3. In the case of power consumption of 10 W, the temperature according to the fourth case CASE4 is lower by 2.9 °C (about 8.8 %) than that of the third case CASE3, and in the case of power consumption of 15 W, the temperature according to the fourth case CASE4 is lower by 4.2 °C (about 11.0 %) than that of the third case CASE3.

As described above, the heat sink HS including the heat pipe FP (see FIG. 4 and FIG. 5) according to embodiments of the present disclosure has higher heat dissipation performance.

FIG. 10 illustrates a perspective view of the heat sink of FIG. 4 according to some embodiments.

Referring to FIG. 4, FIG. 5, and FIG. 10, except for the arrangement of the heat pipe FP_1, the heat sink HS_1 of FIG. 10 may be the same (or substantially the same) as or similar to the heat sink HS of FIG. 5. Therefore, some redundant descriptions will not be repeated.

The heat sink HS_1 includes a heat pipe FP_1 formed inside the main body BD. The heat pipe FP_1 may extend along a first rotation direction perpendicular to the first direction DR1 inside each of the fins FN, and the heat pipe FP_1 may have a double spiral structure entirely extending in the first direction DR1.

For example, the heat pipe FP_1 may include a first spiral structure FP_S1 (or a first sub-heat pipe) and a second spiral structure FP_S2 (or a second sub-heat pipe). The first spiral structure FP_S1 may pass through odd-numbered fins, and the second spiral structure FP_S2 may pass through even-numbered fins.

For example, the first spiral structure FP_S1 may sequentially extend in the direction opposite to the third direction DR3, the direction opposite to the second direction DR2, and the third direction DR3, inside each of the first fin FN1, the third fin FN3, the fifth fin FN5, and the seventh fin FN7. Inside the base BS, the first spiral structure FP_S1 may extend in the fifth direction DR5 from one side of the first fin FN1 to the other side of the third fin FN3, extend in the fifth direction DR5 from one side of the third fin FN3 to the other side of the fifth fin FN5, and extend in the fifth direction DR5 from one side of the fifth fin FN5 to the other side of the seventh fin FN7.

For example, the second spiral structure FP_S2 may sequentially extend in the direction opposite to the third direction DR3, the direction opposite to the second direction DR2, and the third direction DR3, inside each of the second fin FN2, the fourth fin FN4, the sixth fin FN6, and the eighth fin FN8. Inside the base BS, the second spiral structure FP_S2 may extend in the fifth direction DR5 from one side of the second fin FN2 to the other side of the fourth fin FN4, extend in the fifth direction DR5 from one side of the fourth fin FN4 to the other side of the sixth fin FN6, and extend in the fifth direction DR5 from one side of the sixth fin FN6 to the other side of the eighth fin FN8.

According to some embodiments, the heat pipe FP_1 may have a single closed loop structure. For example, at both end portions of the base BS in the first direction DR1 (for example, the first end portion EP1 and the second end portion EP2 of FIG. 5), the first spiral structure FP_S1 and the second spiral structure FP_S2 may be connected to each other to form a closed loop structure. When the heat pipe FP_1 has a single closed loop structure, the working fluid in the heat pipe FP_1 may perform circulation behavior. For example, the working fluid in the heat pipe FP_1 may be circularly moved in the order of the first fin FN1, the third fin FN3, the fifth fin FN5, the seventh fin FN7, the eighth fin FN8, the sixth fin FN6, the fourth fin FN4, and the second fin FN2.

For example, when heat is concentrated and transmitted to the central portion of the heat sink HS_1 (or base BS), the first spiral structure FP_S1 passing through odd-numbered fins may transmit heat to the fifth fin FN5 and the seventh fin FN7, and the second spiral structure FP_S2 passing through even-numbered fins may transmit heat to the second fin FN2. That is, the first spiral structure FP_S1 and the second spiral structure FP_S2 may transmit heat in different directions, and diffuse heat more quickly.

As described above, the heat sink HS_1 includes the heat pipe FP_1 having the double spiral structure, and may diffuse and dissipate heat more quickly through the heat pipe FP_1.

Meanwhile, in FIG. 10, the heat pipe FP_1 is shown as having a single closed loop structure, but embodiments according to the present disclosure are not limited thereto. For example, the first spiral structure FP_S1 and the second spiral structure FP_S2 of the heat pipe FP_1 are not connected or separated, and the heat pipe FP_1 may have two open loop structures.

In addition, in FIG. 10, the heat pipe FP_1 is shown as having a double spiral structure, but is not limited thereto. For example, if each spiral structure entirely passes through the heat sink HS_1, the heat pipe FP_1 may have three or more spiral structures.

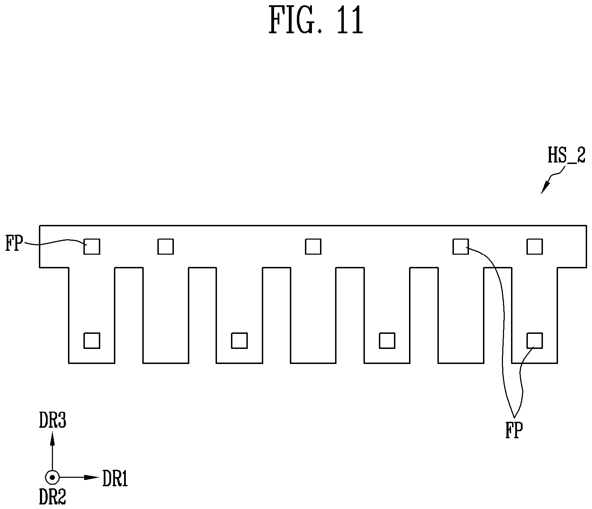

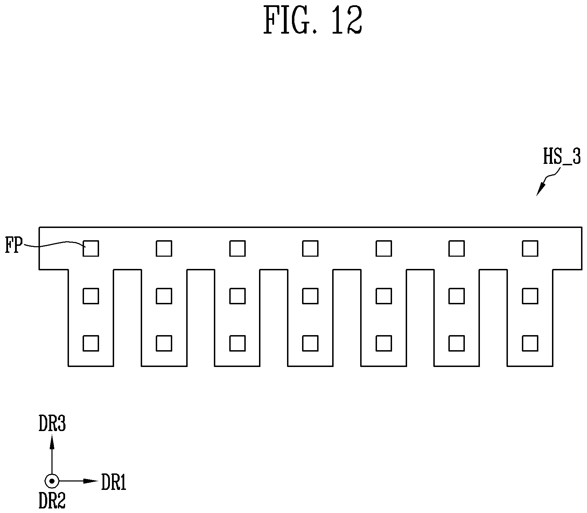

FIG. 11 and FIG. 12 illustrate cross-sectional views of a heat sink included in the display device of FIG. 3 according to some embodiments.

Referring to FIG. 3, FIG. 4, FIG. 5, FIG. 11, and FIG. 12, except for the disposition of the heat pipe FP, each of the heat sinks HS_2 and HS_3 of FIG. 11 and

FIG. 12 may be the same as or similar to the heat sink HS of FIG. 4. Therefore, redundant descriptions will not be repeated.

According to some embodiments, the heat pipe FP of the heat sink HS_2 may pass through only some of the fins FN.

Referring to FIG. 11, for example, the heat pipe FP may pass only through odd-numbered fins FN (or even-numbered fins FN). For example, the heat pipe FP may have only the first spiral structure FP_S1 (or the second spiral structure FP_S2) described with reference to FIG. 10.

According to some embodiments, in a cross-sectional view, the heat pipe FP of the heat sink HS_3 may be located on three layers separated from each other along the third direction DR3.

Referring to FIG. 12, for example, the heat pipe FP may be located on a first layer corresponding to the base BS, a second layer corresponding to a portion contacting the base BS of the fins FN, and a third layer corresponding to the end portions (end portions in the opposite direction of the third direction DR3) of the fins FN. The heat pipe FP may have an open loop structure or a closed loop structure inside each of the fins FN, and the heat pipe FP may be connected entirely inside the base BS. The path of the heat pipe FP inside each of the fins FN is not particularly limited.

For example, the heat pipe FP may have a closed loop structure passing through the second layer and the third layer, similar to the heat pipe FP_C described with reference to FIG. 9. The closed loop structure may extend to the first layer (or base BS) and may be connected to an adjacent closed loop structure inside the base BS.

As another example, the heat pipe FP may include a third spiral structure passing through the first layer and the third layer (for example, arranged along the outermost portion of each fin FN), and a fourth spiral structure passing through the first layer and the second layer (for example, arranged inside the third spiral structure). The fourth spiral structure may have a loop smaller than the third spiral structure in the second direction DR2 and the third direction DR3. The third spiral structure may be separated from or connected to the fourth spiral structure. The third spiral structure and the fourth spiral structure may be connected at any position (for example, both end portions in the first direction DR1) of the base BS.

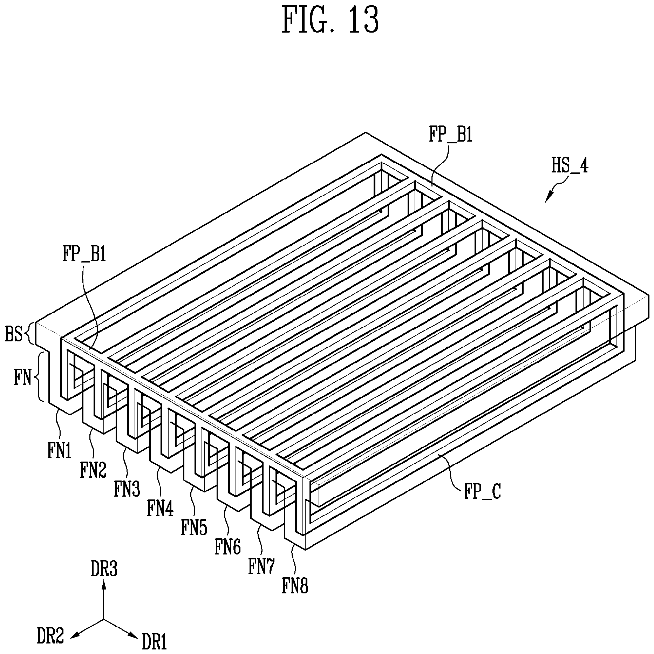

FIG. 13 and FIG. 14 illustrate perspective views of the heat sink of FIG. 4 according to some embodiments.

Referring to FIG. 4, FIG. 5, and FIG. 13, a heat sink HS_4 may include a base BS, fins FN, and a heat pipe FP_C. Because the base BS and the fins FN (the main body including the same) have been described with reference to FIG. 4, redundant descriptions thereof will not be repeated.

Each heat pipe FP_C may be located inside each of the fins FN. The heat pipe FP_C may include closed loop structures (or closed loops) respectively corresponding to the fins FN.

According to some embodiments, the heat pipe FP_C (or closed loop structures) may be connected to the first bridge FP_B1 located inside the base BS. The first bridge FP_B1 may be integrally formed with the heat pipe FP_C (or closed loop structures). The first bridge FP_B1 may be included in the heat pipe FP_C.

For example, the first bridge FP_B1 may extend in the first direction DR1 and may be connected to each heat pipe FP_C (or closed loop structure).

According to some embodiments, the first bridge FP_B1 may be located adjacent to the edge of the base BS rather than the center of the area of the base BS. Referring to FIG. 13, for example, the first bridge FP_B1 may be located adjacent to an end portion of the base BS in the second direction DR2. In addition, the first bridge FP_B1 may be located adjacent to an end portion of the base BS in the direction opposite to the second direction DR2.

According to some embodiments, the first bridge FP_B1 may be located adjacent to the center of the area of the base BS rather than the edge of the base BS. Referring to FIG. 14, for example, the first bridge FP_B1 may be located between the end portion of the base BS and the center of the area of the base BS in the second direction DR2.

As described above, the heat pipe FP_C (or closed loop structures) corresponding to each of the fins FN may be connected inside the base BS through the first bridge FP_B1. Accordingly, heat may be diffused throughout the fins FN, and the heat diffused using all of the fins FN may be dissipated to the outside more quickly.

Meanwhile, in FIG. 13 and FIG. 14, the heat sink HS_4 is shown as including two first bridges FP_B1, but is not limited thereto. For example, the heat sink HS_4 may include three or more first bridges FP_B1. For example, the heat sink HS_4 may include both the first bridge FP_B1 of FIG. 13 and the first bridge FP_B1 of FIG. 14.

Additionally, in FIG. 13 and FIG. 14, the first bridge FP_B1 is shown extending in the first direction DR1, but is not limited thereto. For example, at least one first bridge FP_B1 may extend in an oblique direction crossing the first direction DR1 and the second direction DR2.

In FIG. 13 and FIG. 14, one closed loop structure is illustrated as being located on two layers in the third direction DR3 corresponding to each fin FN, but it is not limited thereto. For example, as described with reference to FIG. 11 and FIG. 12, the closed loop structure may be located on at least some of the fins FN, or the closed loop structure may be located on three or more layers in the third direction DR3.

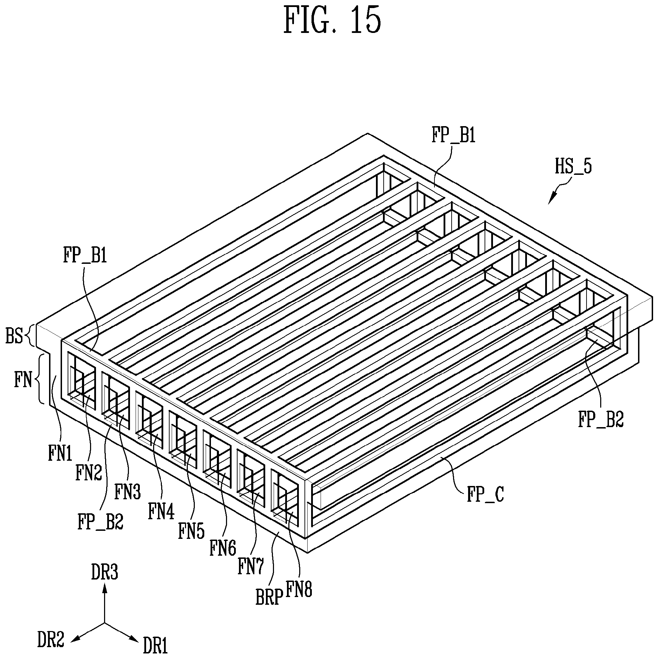

FIG. 15 illustrates a perspective view of the heat sink of FIG. 4 according to some embodiments.

Referring to FIG. 13 and FIG. 15, except for the second bridge FP_B2, the heat sink HS_5 of FIG. 15 may be the same (or substantially the same) as or similar to the heat sink HS_3 of FIG. 13. Therefore, some redundant descriptions will not be repeated.

The heat pipe FP_C (or closed loop structures) may be connected through the second bridge FP_B2 at the end portions of the fins FN. That is, the heat pipe FP_C (or closed loop structures) may be connected outside the base BS rather than inside the base BS.

Each of the fins FN may be connected to an adjacent fin through a connection portion BRP at an end portion in the third direction DR3 and the second direction DR2 (that is, near the edge where the side in the third direction DR3 meets the side in the second direction DR2). The connection portion BRP may be integrally formed with the fins FN. An opening may be formed between the base BS and the connection portion BRP so that air may move in the second direction DR2 between the fins FN.

The second bridge FP_B2 may be formed in the connection portion BRP. The second bridge FP_B2 may be integrally formed with the heat pipe FP_C (or closed loop structures). The second bridge FP_B2 may be included in the heat pipe FP_C.

In FIG. 15, the second bridge FP_B2 is shown as being arranged at both end portions of the fins FN in the second direction DR2, corresponding to the first bridge FP_B1, but is not limited thereto. For example, the second bridge FP_B2 may be located adjacent to the center of the area of the base BS rather than the edge of the base BS, corresponding to the first bridge FP_B1 of FIG. 14. Similar to the first bridge BPR1 described with reference to FIG. 13 and FIG. 14, the number, disposition position, extension direction, and the like of the second bridge BRP2 may be variously changed.

As discussed, embodiments can provide a display device comprising: a display panel; and a heat sink under the display panel, wherein the heat sink includes: a main body including a base and fins that protrude downward from the base and are spaced apart from each other; and a heat pipe formed inside the main body and having a path passing through the base and the fins.

The display panel may emit light in a direction away from the heat sink.

Embodiments can provide a heat sink comprising: a main body including a base and fins that protrude downward from the base and are spaced apart from each other; and a heat pipe formed inside the main body and having a path passing through the base and the fins.

Aspects of some embodiments of the present disclosure have been described above, but it should be noted that the disclosed embodiments are provided only for illustration while not limiting the present disclosure. In addition, it will be understood by those skilled in the art that various changes in form and details may be made therein without departing from scope of embodiments according to the present disclosure.

## Claims

1. A heat sink comprising:
a main body including a base and fins that protrude downward from the base and are spaced apart from each other; and
a heat pipe formed inside the main body and having a path passing through the base and the fins.

2. The heat sink of claim 1, wherein the heat pipe is a pulsating heat pipe; optionally
wherein the heat pipe is not connected to an external device or a power source.

3. The heat sink of claim 1 or 2, wherein the fins are arranged along a first direction, and
wherein the heat pipe extends inside each of the fins along a first rotation direction perpendicular to the first direction, and the heat pipe has a spiral structure extending along the first direction.

4. The heat sink of claim 3, wherein each of the fins is a plate fin, and the heat pipe extends along an edge of each of the fins.

5. The heat sink of claim 3 or 4, wherein the heat pipe has an open loop structure, and
wherein one end portion of the heat pipe is connected to the other end portion of the heat pipe only through a single path.

6. The heat sink of any one of claims 3 to 5, wherein the heat pipe has a single closed loop structure;
optionally wherein the heat pipe has a double spiral structure extending along the first direction;
optionally wherein the heat pipe includes a first spiral structure passing through odd-numbered fins among the fins, and a second spiral structure passing through even-numbered fins among the fins, and wherein the first spiral structure and the second spiral structure are connected to each other at both end portions of the base in the first direction to form the closed loop structure.

7. The heat sink of any one of claims 1 to 6, wherein the heat pipe passes through only some of the fins.

8. The heat sink of any one of claims 1 to 7, wherein in a cross-sectional view, the heat pipe is on at least two layers that are separated from each other along a third direction in which the fins protrude from the base;
optionally wherein in a cross-sectional view, the heat pipe is on three layers.

9. The heat sink of any one of claims 1 to 8, wherein the fins are sequentially arranged along a first direction;
wherein the heat pipe extends inside each of the fins along a first rotation direction perpendicular to the first direction, and the heat pipe has a spiral structure extending along the first direction; and
wherein the heat pipe has an open loop structure.

10. The heat sink of any one of claims 1 to 8, wherein the fins are sequentially arranged along a first direction,
wherein the heat pipe includes:
closed loops respectively corresponding to the fins; and
a first bridge extending in the first direction inside the base and connected to the closed loops, and
wherein the closed loops and the first bridge are integrally formed.

11. The heat sink of claim 10, wherein the first bridge is closer to an edge of the base than a center of an area of the base; or
wherein the first bridge is closer to a center of an area of the base than an edge of the base.

12. The heat sink of claim 10 or 11, wherein the heat pipe further includes a second bridge connecting the closed loops at end portions of the fins.

13. The heat sink of any one of claims 1 to 12, wherein a filling rate of a working fluid in the heat pipe is in a range of 40 % to 70 %.

14. A display device comprising:
a display panel; and
a heat sink under the display panel,
wherein the heat sink is according to any one of claims 1 to 13.

15. The display device of claim 14, wherein the heat sink is coupled to a lower surface of the display panel by a heat dissipation adhesive or a single heat dissipation adhesive layer.
